Europäisches Patentamt

European Patent Office

Office européen des brevets

(19)

(11) **EP 1 272 860 B1**

(12) **EUROPÄISCHE PATENTSCHRIFT**

(45) Veröffentlichungstag und Bekanntmachung des Hinweises auf die Patenterteilung:
**10.08.2005 Patentblatt 2005/32**

(51) Int Cl.[7]: **G01R 31/26**, G01N 27/00

(21) Anmeldenummer: 01929287.9

(86) Internationale Anmeldenummer:
**PCT/DE2001/001239**

(22) Anmeldetag: **29.03.2001**

(87) Internationale Veröffentlichungsnummer:
**WO 2001/075462 (11.10.2001 Gazette 2001/41)**

(54) **SENSOR-ANORDNUNG UND VERFAHREN ZUM ERFASSEN EINES ZUSTANDS EINES TRANSISTORS EINER SENSOR-ANORDNUNG**

SENSOR ARRAY AND METHOD FOR DETECTING THE CONDITION OF A TRANSISTOR IN A SENSOR ARRAY

DISPOSITIF DE CAPTEURS ET PROCEDE POUR SAISIR L'ETAT D'UN TRANSISTOR D'UN DISPOSITIF DE CAPTEURS

(84) Benannte Vertragsstaaten:
**AT BE CH CY DE DK ES FI FR GB GR IE IT LI LU MC NL PT SE TR**

(30) Priorität: **30.03.2000 DE 10015958**
**12.05.2000 DE 10023357**

(43) Veröffentlichungstag der Anmeldung:
**08.01.2003 Patentblatt 2003/02**

(73) Patentinhaber: **Infineon Technologies AG**
**81669 München (DE)**

(72) Erfinder: **THEWES, Roland**
**82194 Gröbenzell (DE)**

(74) Vertreter: **Viering, Jentschura & Partner**
**Postfach 22 14 43**
**80504 München (DE)**

(56) Entgegenhaltungen:
**EP-A- 0 310 230         JP-A- 11 044 587**
**US-A- 4 568 444**

- **L. BOUSSE ET AL: "A Process for the Combined Fabrication of Ion Sensors and CMOS Sensors" IEEE ELECTRON DEVICE LETTERS, Bd. 9, Nr. 1, Januar 1998 (1998-01), Seiten 44-46, XP001008777 USA**

## Beschreibung

Die Erfindung betrifft eine Sensor-Anordnung sowie ein Verfahren zum Erfassen eines Zustands eines Transistors einer Sensor-Anordnung.

Eine solche Sensor-Anordnung und ein solches Verfahren sind aus [1] bekannt.

Bei der aus [1] bekannten Sensor-Anordnung sind MOS-Feldeffekttransistoren vorgesehen, die in einer Matrix mit N Zeilen und M Spalten angeordnet sind und über Spaltenverbindungen bzw. Zeilenverbindungen miteinander gekoppelt sind. Die Spaltenverbindungen bzw. Zeilenverbindungen sind üblicherweise elektrische leitende Verbindungen. Ferner ist ein Auswahlmittel vorgesehen zum Auswählen eines Feldeffekttransistors, dessen Zustand erfasst werden soll.

Bei der aus [1] bekannten Sensor-Anordnung sind die Feldeffekttransistoren als Sensoren ausgestaltet, das heißt, sie erfassen ein zu erfassendes Signal, beispielsweise mittels eines sich ändernden Gatepotentials des jeweiligen Feldeffekttransistors.

Durch die Sensor-Anordnung wird bei Auswählen eines Feldeffekttransistors und bei Auslesen des Zustands eine nichtlineare Kennlinie des Verlaufs der Spannung ermittelt, welche Spannung zwischen Source und Drain des jeweiligen Feldeffekttransistors anliegt. Der Verlauf der ausgelesenen Spannung ist nicht-linear.

Aufgrund dieser Nicht-Linearität ergeben sich in der praktischen Anwendung der bekannten Sensor-Anordnung erhebliche Probleme.

Insbesondere bei Sensor-Anordnungen, die eine hohe örtliche Auflösung erreichen sollen, beispielsweise bei Sensor-Anordnungen, deren Feldeffekttransistoren in einer sehr großen Anzahl von mehreren Tausend bis zu mehreren Millionen in einem Abstand von jeweils 5 µm und weniger voneinander beabstandet angeordnet sind, treten große Verlässlichkeitsprobleme hinsichtlich des zu erfassenden Zustands des ausgewählten Transistors auf. In anderen Worten sind die Verlässlichkeitsprobleme insbesondere zu beobachten bei einem sehr kleinen Verhältnis der Dimension der Sensor-Anordnung bezogen auf die Anzahl der in der Sensor-Anordnung enthaltenen Feldeffekttransistoren.

Dies bedeutet, dass bei steigender Ortsauflösung der Sensor-Anordnung bei gleichbleibender oder sogar steigender Gesamtfläche der Sensor-Anordnung, oder entsprechend bei gleichbleibender Ortsauflösung und bei steigender Gesamtfläche der Sensor-Anordnung erhebliche Verlässlichkeitsprobleme beim Erfassen bioelektrischer Signale auftreten.

Ferner ist die in [1] verwendete Technologie sehr kompliziert und teuer in der Herstellung und mit üblichen Standard-Herstellungsprozessen in der Industrie sehr wenig kompatibel.

Ferner ist es bekannt, MOS-Feldeffekttransistoren derart zu modifizieren, dass sie als Sensoren verwendet werden können.

Bei einem solchen Feldeffekttransistor erfolgt die Steuerung des Kanals bzw. die Steuerung der Dichte der im Kanalbereich vorhandenen Ladungsträger über das durch den Sensor zu charakterisierende Objekt oder Medium derart, dass das Objekt oder Medium auf das Potential an der Oberfläche des über dem Kanalbereich liegenden Dielektrikums einwirkt und den Zustand des entsprechenden Feldeffekttransistors verändert. Der Zustand des Feldeffekttransistors wird über die Source-Anschlüsse und Drain-Anschlüsse ausgelesen.

Bei üblichen, nicht modifizierten MOS-Feldeffekttransistor-Schaltungsanordnungen, beispielsweise bei einer üblichen Speicheranordnung von Transistoren in Form einer Matrix (z.B. ein **R**andom **A**ccess **M**emory (RAM)), wird der Zustand eines Feldeffekttransistors über die Source-Anschlüsse und Drain-Anschlüsse verändert und ausgelesen wird.

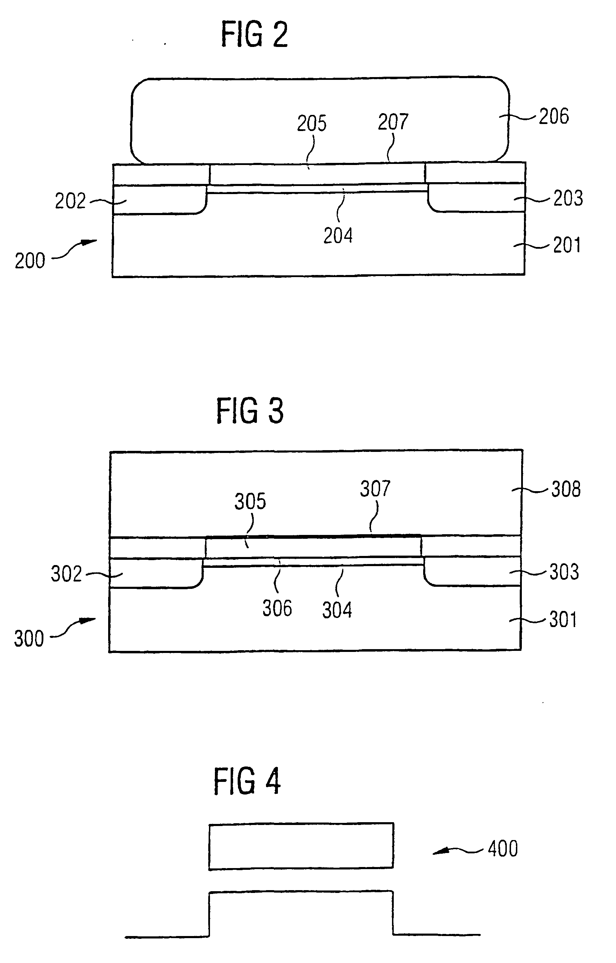

Eih Beispiel für einen solchen modifizierten Feldeffekttransistor ist in **Fig.2** dargestellt.

Der Feldeffekttransistor 200 weist ein Substrat 201, einen Source-Bereich 202, einen Drain-Bereich 203, einen Kanalbereich 204 und ein für Anwendungen in der Bio-Sensorik oder Bio-Elektronik speziell angepasstes Isolatordielektrikum 205 auf. Oberhalb des Isolatordielektrikums 205 ist im Rahmen der Bio-Sensorik oder Bio-Elektronik eine Zelle 206 aus biologischem Material angeordnet.

Wie in [2] und [3] beschrieben worden ist, können mit Hilfe eines solchen Feldeffekttransistors 200 neuronale Signale der Zelle 206 aus biologischem Material, die sich in Form von Potentialänderungen an der Zellwand 207 der Zelle 206 äußern, erfasst und charakterisiert werden. Dies ist möglich, indem die Potentialänderungen an der Zellwand 207 den Kanalstrom der Ladungsträger in dem Feldeffekttransistor 200 bzw. die Dichte der im Kanalbereich 204 des Feldeffekttransistors 200 vorhandenen Ladungsträger steuern und modulieren.

Ein solcher Feldeffekttransistor 200 ist derart eingerichtet, dass Stoffwechselprodukte der Zelle 206 den Feldeffekttransistor 200 nicht schädigen und in seinen Eigenschaften nicht verändern.

Weiterhin haben die verwendeten Sensormaterialien des Feldeffekttransistors 200, die in Kontakt stehen mit der Zelle 206, keine Einwirkungen auf den Stoffwechsel der Zelle 206 und ihre Funktion und wirken gegenüber der Zelle 206 nicht toxisch.

Ein weiterer Feldeffekttransistor 300, ein sogenannter ionensensitiver Feldeffekttransistor wird üblicherweise eingesetzt zum Bestimmen eines pH-Wertes einer zu untersuchenden Lösung. Allgemein kann der ionensensitive Feldeffekttransistor 300 auch in der Gas-Sensorik eingesetzt werden. Der Feldeffekttransistor 300 weist ein Substrat 301, einen Source-Bereich 302, einen Drain-Bereich 303, einen Kanalbereich 304, ein Isolatordielektrikum 305 auf, wobei die nicht mit dem Substrat 301 in Kontakt stehende Grenzfläche 306 des Isolatordielektrikums 305 bzw. der den Erfassungsbereich bildende Dielektrikumsbereich 307 eine große Anzahl sogenannter Grenzflächenzustände enthält. An diesen Grenzflächenzuständen lagern sich entsprechend der Konzentration des zur Auswertung herangezogenen Parameters des zu charakterisierenden Mediums 308 Ionen an, bei der Ausgestaltung des Feldeffekttransistors 300 als pH-Wert-Senor $H^+$-Ionen. In anderen Worten bedeutet dies, dass eine Wechselwirkung zwischen dem zu untersuchenden Medium 308 und dem Feldeffekttransistor 300 stattfindet. Der durch die Wechselwirkung bedingte Potentialeffekt wirkt sich in deterministischer Weise auf den Kanalstrom der Ladungsträger innerhalb des Kanalbereichs 304 bzw. auf die Dichte der im Kanalbereich 304 des Feldeffekttransistors 300 vorhandenen Ladungsträger aus.

Insbesondere in der Bio-Sensorik oder Bio-Elektronik ist es wünschenswert, solche oben beschriebenen Feldeffekttransistor-Sensoren in einer großen Anzahl innerhalb einer Sensor-Anordnung vorzusehen, um eine genaue ortsauflösende und zeitauflösende Erfassung eines oder mehrerer zu erfassender Parameter einer gegebenen Probe, beispielsweise einer Probe von Zellen 206 oder einer Gasprobe als Medium 308, zu ermöglichen.

Eine mögliche Anwendung solcher Sensor-Anordnungen ist in der Charakterisierung der neuronalen Aktivitäten von einer Vielzahl miteinander gekoppelter biologischer Zellen zu sehen. Bei einer solchen Sensor-Anordnung sollen die Sensoren, das heißt die Feldeffekttransistoren, in einer Matrix mit jeweils entlang einer Zeile und einer Spalte von mehreren tausend Feldeffekttransistoren angeordnet sein, jeweils voneinander beabstandet in einem Abstand, der geringer ist als 5 µm * 5 µm. Der in einer solchen Anwendung zur Verfügung stehende Signalhub des zu erfassenden elektrischen Signals kann dabei Werte in einer Größenordnung mehrerer Mikrovolt (µV) aufweisen.

Ferner ist aus [4] ein Array mit einer Vielzahl von Transistoren und einer Vielzahl von Sensorelementen bekannt, wobei jeweils ein Sensorelement jeweils einem Transistor vorgeschaltet ist. Die Transistoren teilen sich einen gemeinsamen, an den gemeinsamen Reihenausgang der Transistoren geschalteten Source-Folgerwiderstand.

In [5] sind ein Verfahren zur Herstellung von mikro- und nanostrukturierten Kohlenstoffschichten, Kohlenstoffelektroden und chemische Feldeffekttransistoren bekannt.

Aus [6] ist ein Fingerabdruck-Sensor bekannt, der eine Mehrzahl von FET-Transistoren aufweist, die als Drucksensoren angewendet werden, wobei an wenigstens einigen FET-Transistoren ein konstanter Strom bereitgestellt wird, und die FET-Transistoren eine Source-Folger-Funktion ausführen.

Aus [7] ist eine Vorrichtung zum Messen der Quantitäten von chemischen Substanzen bekannt, die in einer Lösung enthalten sind, indem ein Sensor verwendet wird, der für chemische Substanzen empfänglich ist, welche Vorrichtung einer potentiometrischen Elektrode und einer Referenzelektrode mit flüssiger Grenzschicht.

Aus [8] ist ein Verfahren zum Herstellen von Ionen-sensitiven Feldeffekttransistoren zusammen mit CMOS-Schaltkreisen bekannt, wobei die FETs mit Floating-Polysilizium-Gates gebildet sind

Der Erfindung liegt das Problem zugrunde, eine Sensor-Anordnung anzugeben, die bei einer sehr hohen Ortauflösung bis zu einer Ortsauflösung, bei denen die Feldeffekttransistoren in einem Abstand von bis zu 5 µm * 5 µm und darunter angeordnet sind, mit einer sehr großen Anzahl von bis zu mehreren Tausend bis zu mehreren Millionen Feldeffekttransistoren, zum Erfassen bioelektrischer Signale einsetzbar sind.

Weiterhin liegt der Erfindung das Problem zugrunde, ein Verfahren zum Erfassen eines Zustandes eines Transistors einer Sensor-Anordnung anzugeben mit bis zu mehreren Millionen Feldeffekttransistoren, die einer Ortauflösung von bis zu 5 µm * 5 µm und darunter angeordnet sind, wobei die Feldeffekttransistoren zum Erfassen bioelektrischer Signale einsetzbar sind.

Das Problem wird durch die Sensor-Anordnung sowie durch das Verfahren zum Erfassen eines Zustandes eines Transistors einer Sensor-Anordnung mit den Merkmalen gemäß den unabhängigen Patentansprüchen gelöst.

Eine Sensor-Anordnung weist Transistoren (Transistorelemente) auf, die miteinander gekoppelt sind. Die Transistoren selbst, vorzugsweise Feldeffekttransistoren, sind als Sensoren ausgestaltet. Ferner ist ein Auswahlmittel vorgesehen, dass zum Auswählen eines Transistors dient, dessen Zustand erfasst werden soll. Die Sensor-Anordnung ist derart eingerichtet, dass der ausgewählte Transistor selbst zumindest bei erfolgter Auswahl als Sourcefolger betreibbar ist.

Bei einem Verfahren zum Erfassen eines Zustands eines Transistors einer Sensor-Anordnung, die miteinander gekoppelte Transistoren aufweist, werden die Transistoren als Sensoren verwendet. Dies bedeutet, dass der Zustand eines Transistors abhängig ist von einem zu erfassenden Signal, das von dem Transistor erfasst wird. Der Transistor wird ausgewählt und der Zustand des ausgewählten Transistors wird erfasst. Zumindest bei erfolgter Auswahl wird der ausgewählte Transistor als Sourcefolger betrieben.

Durch die Erfindung wird es erstmals möglich, eine Sensor-Anordnung mit einer großen Anzahl von Transistoren, bis zu einigen Millionen Transistoren, als hochortsauflösende und hochzeitauflösende Sensor-Anordnung bereitzustellen.

Insbesondere durch das Betreiben des ausgewählten Transistors als Sourcefolger, das heißt in einem Arbeitspunkt, in dem die Sourcespannung des ausgewählten Feldeffekttransistors im wesentlichen linear abhängig ist von der angelegten Gatespannung an den Feldeffekttransistors, die das Potential der zu untersuchenden Probe repräsentiert, wird die Anordnung mit einer derart hohen örtlichen und zeitlichen Auflösung überhaupt störungsfrei und damit stabil möglich.

Die Sensor-Anordnung ist gegenüber Störungseinflüssen robust und es ist sichergestellt, dass die bioelektrischen Signale beispielsweise der Zelle 206 oder des Mediums 308 sehr exakt erfasst werden können.

Bevorzugte Weiterbildung der Erfindung ergeben sich aus den abhängigen Ansprüchen.

Zumindest ein Teil der Transistoren können Feldeffekttransistoren sein. Gemäß einer Ausgestaltung der Erfindung sind zumindest ein Teil der Feldeffekttransistoren MOS-Feldeffekttransistoren.

Zumindest ein Teil der MOS-Feldeffekttransistoren können derart eingerichtet sein, das sie biologisches Material erfassen können.

Gemäß einer weiteren Ausgestaltung der Erfindung ist es vorgesehen, dass zumindest ein Teil der Transistoren ionensensitive Feldeffekttransistoren sind. Auf diese Weise ist es möglich, die Sensor-Anordnung beispielsweise in der Gas-Sensorik oder zum Bestimmen eines pH-Wertes von Lösungen einzusetzen.

Der ausgewählte Transistor kann beispielsweise als Sourcefolger betrieben werden. Der ausgewählte Transistor kann zumindest bei erfolgter Auswahl in einem Arbeitspunkt in Inversion betrieben wird. Alternativ kann der ausgewählte Transistor zumindest bei erfolgter Auswahl in einem Arbeitspunkt im Unterschwellenbereich des Transistors betrieben werden.

Gemäß einer weiteren Ausgestaltung der Erfindung ist es vorgesehen, zum Erfassen eines Zustands des ausgewählten Transistors eine Spannung anzulegen, die gleich ist der Betriebsspannung der Sensor-Anordnung. Durch diese Weiterbildung ist die gesamte Sensor-Anordnung sehr kompakt und einfach realisierbar, da die Betriebsspannung auch zum Erfassen des Zustands des jeweils ausgewählten Transistors verwendet werden kann.

Die Transistoren können kompakt in Spalten und in Zeilen in Form einer Matrix angeordnet sein und über Spaltenverbindungen und Zeilenverbindungen ähnlich der Verbindungsstruktur einer Matrix eines üblichen Halbleiter-Speichers miteinander gekoppelt sein.

Gemäß einer weiteren Ausgestaltung der Erfindung ist eine Stromquelle vorgesehen, die mit den Source-Anschlüssen der Feldeffekttransistoren koppelbar ist. Es kann auch eine Spannungsquelle vorgesehen sein, die mit den Drain-Anschlüssen der Feldeffekttransistoren koppelbar ist. Die Sensor-Anordnung gemäß dieser Ausgestaltung eignet sich insbesondere zur Kompensation von Signalfehlern, die innerhalb des Sensor-Anordnung auftreten können.

Die Auswahlmittel können Schalter aufweisen, mittels derer ein Transistor auswählbar ist.

Insbesondere zum Verringern möglicher parasitärer Effekte, die insbesondere bei reduzierten Dimensionen der Sensor-Anordnung bei gleichbleibender oder wachsender Anzahl von Feldeffekttransistoren in der Sensor-Anordnung auftreten können, ist es gemäß einer Ausgestaltung der Erfindung vorgesehen, jedem Transistor ein Auswahlelement zuzuordnen, mit dem der ausgewählte Transistor leitend mit dem Auswahlmittel koppelbar ist und mit dem, wenn der Transistor nicht ausgewählt ist, der Stromfluss durch diesen elektrisch sperrbar ist.

Das Auswahlelement kann eine Diode oder ein Transistor sein.

Weiterhin kann eine Pufferschaltung, beispielsweise mit einem Operationsverstärker, vorgesehen sein, die mit den Transistoren, vorzugsweise mit den Zeilenverbindungen der Feldeffekttransistoren gekoppelt ist. Mit der Pufferschaltung wird jeweils der erfasste Zustand über die Zeilenverbindungen und das Pufferelement an einem Ausgang der Pufferschaltung zur Weiterverarbeitung bereitgestellt, wobei beispielsweise das an dem Ausgang bereitgestellte Signal, welches den Zustand repräsentiert, belastbar und niederohmig ist. Alternativ kann im Rahmen der Erfindung eine beliebige elektrische Schaltung als Pufferschaltung eingesetzt werden, die die oben dargestellte Funktionalität gewährleistet, d.h. die gewährleistet, dass ein an dem Eingang der Pufferschaltung anliegendes Eingangssignal an dem Ausgang der Pufferschaltung niederohmig bereitgestellt wird.

Durch die Pufferschaltung wird somit eine Rückwirkung der an deren Ausgang abgegriffenen Signale auf die Sensor-Anordnung vermieden.

Bevorzugt wird das an dem Ausgang der Pufferschaltung anliegende Signal über Spaltenverbindungen den Transistoren der Sensor-Anordnung zur Verfügung gestellt, um zumindest einem Teil der nicht ausgewählten Transistoren mit einem vorgegebenen elektrischen Potential, das dem an dem Ausgang der Pufferschaltung anliegenden Potential entspricht, zuzuführen.

Ausführungsbeispiele der Erfindung sind in den Figuren dargestellt und werden im weiteren näher erläutert.

Es zeigen

Figur 1     eine Sensor-Anordnung gemäß einem ersten Ausführungsbeispiel der Erfindung.

Figur 2 eine Skizze eines Feldeffekttransistors mit biologischem Material.

Figur 3 eine Skizze eines ionensensitiven Feldeffekttransistors.

Figur 4 eine Skizze eines Symbols eines als Sensor ausgestalteten Transistors, das im Rahmen der Beschreibung der Ausführungsbeispiele verwendet wird.

Figur 5a und 5b elektrische Ersatzschaltbilder der in Figur 1 gezeigten Sensor-Anordnung ohne Pufferschaltung (Figur 5a) und mit Pufferschaltung (Figur 5b).

Figur 6 eine Sensor-Anordnung gemäß einem zweiten Ausführungsbeispiel der Erfindung.

Figur 7 eine Sensor-Anordnung gemäß einem dritten Ausführungsbeispiel der Erfindung.

Figur 8 die Sensor-Anordnung gemäß Figur 4 mit zusätzlich berücksichtigten Parasitärwiderständen in den Verbindungsleitungen zwischen den einzelnen Feldeffekttransistoren.

Figur 9 eine Sensor-Anordnung gemäß einem vierten Ausführungsbeispielbeispiel der Erfindung.

Figur 10 eine Sensor-Anordnung gemäß einem fünften Ausführungsbeispiel der Erfindung, wobei jedem Feldeffekttransistor ein Auswahlelement zugeordnet ist.

Figur 11 das elektrische Ersatzschaltbild der in Figur 10 gezeigten Sensor-Anordnung.

Figur 12 eine Sensor-Anordnung gemäß einem sechsten Ausführungsbeispiel der Erfindung.

Figur 13 eine Sensor-Anordnung gemäß einem siebten Ausführungsbeispiel der Erfindung.

Figur 14 eine Sensor-Anordnung gemäß einem achten Ausführungsbeispiel der Erfindung.

Figur 15 ein elektrisches Ersatzschaltbild der in Figur 14 dargestellten Sensor-Anordnung.

Figur 16 eine Sensor-Anordnung gemäß einem neunten Ausführungsbeispiel der Erfindung.

Figur 17 ein elektrisches Ersatzschaltbild der Sensor-Anordnung aus Figur 16.

Im weiteren werden gleiche Elemente in den Figuren mit gleichen Bezugszeichen bezeichnet.

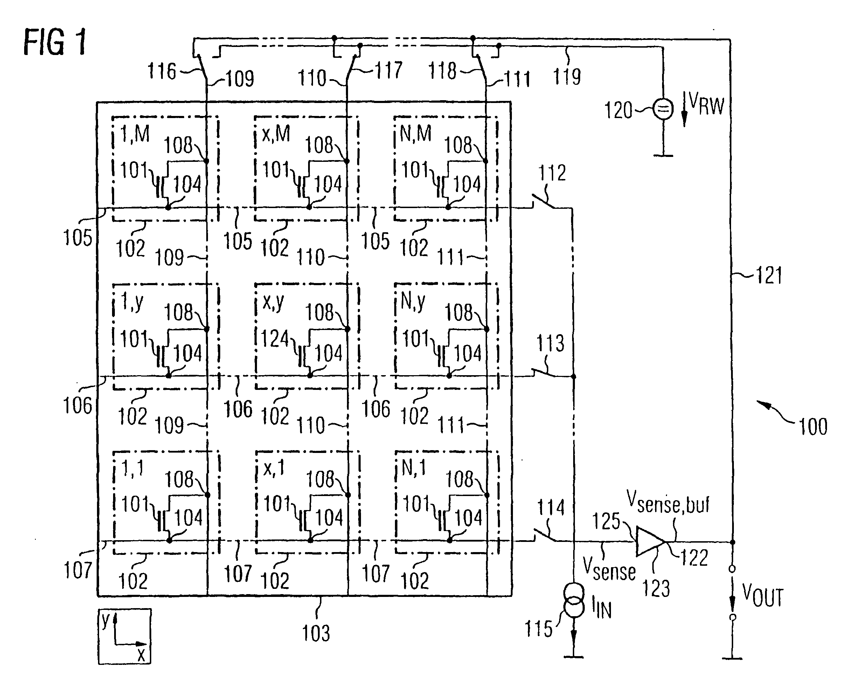

**Fig.1** zeigt eine Sensor-Anordnung 100 gemäß einem ersten Ausführungsbeispiel der Erfindung.

Die Sensor-Anordnung 100 weist MOS-Feldeffekttransistoren 101 auf, die als Sensor ausgestaltet sind.

Als ein solcher Feldeffekttransistor kann beispielsweise der in **Fig.2** oder auch der in **Fig.3** dargestellte Feldeffekttransistor verwendet werden.

Weiterhin können alternativ die in [1] und in [2] beschriebenen Feldeffekttransistoren als Sensor in der Sensor-Anordnung 100 verwendet werden.

Jeder Feldeffekttransistor 101 bildet eine Sensorzelle 102.

Die Sensor-Anordnung 100 weist M * N Sensorzellen 102 auf, wobei die Sensorzellen 102 und damit die Feldeffekttransistoren 101 in N Spalten und M Zeilen in Form einer Matrix 103 angeordnet sind. Dies bedeutet, dass die Sensor-Anordnung 100 in jeder Zeile N Sensorzellen 102 aufweist. Die Sensor-Anordnung 100 weist M Zeilen auf, das heißt in jeder Spalte der Sensor-Anordnung 100 M Sensorzellen 102.

**Fig.4** zeigt das Symbol 400 für einen Feldeffekttransistor 101, wie es im Rahmen der weiteren Beschreibung verwendet wird.

Source-Anschlüsse 104 jedes Feldeffekttransistors 101 sind jeweils mit einer Zeilenverbindung (einer elektrischen Leitung) 105, 106, 107 gekoppelt, so dass die Source-Anschlüsse 104 aller Feldeffekttransistoren 101 in einer Zeile jeweils mit einer Zeilenverbindung 105, 106, 107 gekoppelt sind.

Die Drain-Anschlüsse 108 aller Feldeffekttransistoren 101 sind mit Spaltenverbindungen 109, 110, 111, vorzugsweise elektrischen Leitungen gekoppelt, so dass jeweils die Drain-Anschlüsse 108 der Feldeffekttransistoren 101 einer Spalte jeweils mit der entsprechenden Spaltenverbindung 109, 110, 111 gekoppelt sind.

Mit jeder Zeilenverbindung 105, 106, 107 ist jeweils ein Zeilenauswahlschalter 112, 113, 114 als Auswahlmittel verbunden. Befindet sich der jeweilige Zeilenauswahlschalter 112, 113, 114 in geöffneter Stellung, so fließt durch die jeweilige Zeilenverbindung 105, 106, 107 kein Strom.

Ist der jeweilige Zeilenauswahlschalter 112, 113, 114 jedoch geschlossen, so fließt ein von einer Stromquelle 115 bereitgestellter eingeprägter Strom $I_{IN}$ durch die entsprechende Zeilenverbindung, 105, 106, 107.

Weiterhin ist für jede Spaltenverbindung 109, 110, 111 jeweils ein Spaltenauswahlschalter 116, 117, 118 als Auswahlmittel vorgesehen.

In einer ersten Schalterposition, die der Auswahl der entsprechenden Spaltenverbindung 109, 110, 111, entspricht, das heißt, in dem Fall, dass ein Feldeffekttransistor 101, der mit der jeweils ausgewählten Spaltenverbindung 109, 110, 111, in **Fig.1** die zweite Spaltenverbindung 110, gekoppelt ist, ausgewählt werden soll, ist die jeweils ausgewählte Spaltenverbindung 109, 110, 111 mit einer ersten Verbindungsleitung 119 gekoppelt, die mit einer Spannungsquelle 120 gekoppelt ist. Die Spannungsquelle 120 liefert eine Betriebsspannung $V_{RW}$, die zum Auswählen des entsprechenden Feldeffekttransistors 101 oder 124 dient.

In der zweiten Schalterposition ist der jeweilige Spaltenauswahlschalter 116, 117, 118 mit einer zweiten Verbindungsleitung 121 verbunden, über die der jeweilige Schalter mit dem Ausgang 122 einer Pufferschaltung 123 gekoppelt ist.

Die Pufferschaltung 123 kann gemäß den Ausführungsbeispielen beispielsweise ein Operationsverstärker sein, dessen nichtinvertierender Eingang mit den Zeilenverbindungen 105, 106, 107 koppelbar ist und dessen invertierender Eingang mit dem Ausgang des Operationsverstärkers gekoppelt ist.

Es ist in diesem Zusammenhang anzumerken, dass ohne weiteres eine andere elektrische Schaltung eingesetzt werden kann als Pufferschaltung 123, die ein an ihrem Eingang anliegendes Eingangssignal an ihrem Ausgang niederohmig zur Verfügung stellt.

Im weiteren wird das elektrische Potential des Signals, welches auf den Kanalbereich des jeweiligen Feldeffekttransistor 101 einwirkt, das heißt das durch den Feldeffekttransistor als Sensor zu charakterisierende Signal, mit $V_{char}$ bezeichnet.

Durch Wahl der Zeilenauswahlschalter 112, 113, 114 und der Spaltenauswahlschalter 116, 117, 118 wird der eingeprägte Strom $I_{IN}$ in den Feldeffekttransistor 124 der ausgewählten Zeile, in **Fig.1** der zweiten Zeilenverbindung 106, eingeprägt.

Mittels der Spaltenauswahlschalter 116, 117, 118 wird ein gepuffertes Messsignal $V_{sense,buf}$ welches an dem Ausgang 122 der Pufferschaltung 123 anliegt, das bezüglich seines Wertes dem mit der Verstärkung 1 verstärkten Messsignal $V_{sense}$ entspricht, der Sensor-Anordnung 100, zugeführt, und zwar den Spaltenverbindungen 109, 111 der Feldeffekttransistoren 101, die nicht ausgewählt worden sind.

Durch diese Anordnung ist sichergestellt, dass alle Feldeffekttransistoren 101, die mit einer nicht ausgewählten Spaltenverbindung 109, 111 gekoppelt sind, mit einer Potentialdifferenz von null Volt zwischen Drain und Source des jeweiligen Feldeffekttransistors 101 betrieben werden und somit stromlos sind.

Somit ist gewährleistet, dass der eingeprägte Strom $I_{IN}$ ohne Verlust durch den ausgewählten Sensortransistor 124 an der Position (x, y) fließt, wobei mit x die Spalte bezeichnet wird, in der sich der ausgewählte Feldeffekttransistor befindet, und wobei mit y die Zeile bezeichnet wird, in der sich der ausgewählte Feldeffekttransistor befindet.

Es ist in diesem Zusammenhang anzumerken, dass die nicht ausgewählten Zeilenverbindungen 105, 107 grundsätzlich mit einem beliebigen Potential innerhalb der für die jeweilige Sensor-Anordnung spezifischen Betriebsspannungsgrenzen gemäß der verwendeten Technologie verbunden werden können.

Alternativ können die entsprechenden Zeilenauswahlschalter einfach geöffnet werden.

Weiterhin ist es alternativ möglich, alle nicht ausgewählten Zeilenverbindungen 105, 107 mit dem Ausgang 122 der Pufferschaltung 123 zu koppeln.

Diese Kopplung hat insbesondere bezüglich der Zugriffszeit auf einen Feldeffekttransistor 101 innerhalb der Sensor-Anordnung 100 Vorteile, da das Potential der jeweils neu ausgewählten Zeilenverbindung schon bei deren Auswahl nahe dem Potentialwert liegt, der durch den neu ausgewählten Sensor bestimmt wird. Somit muss eine geringere Menge elektrischer Ladung fließen, bis sich das neue Potential einstellt.

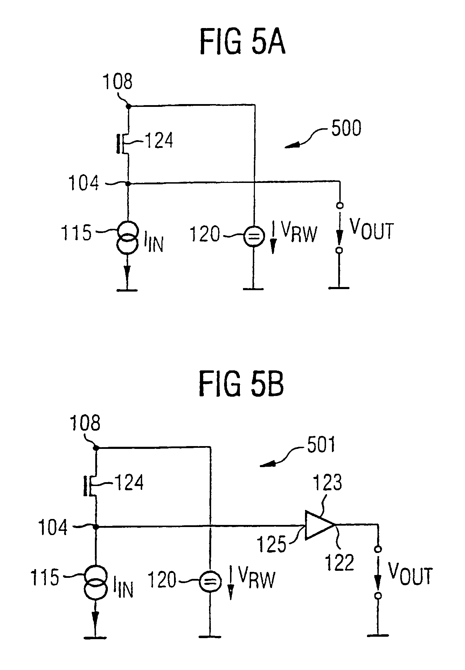

**Fig.5a** und **Fig.5b** zeigen das elektrische Ersatzschaltbild für den in **Fig.1** dargestellten ausgewählten Feldeffekttransistor 124 der Sensor-Anordnung 100, wobei **Fig.5a** das elektrische Ersatzschaltbild 500 ohne Pufferschaltung 123 und **Fig.5b** das elektrische Ersatzschaltbild 501 mit Pufferschaltung 123 zeigt, was bezüglich des Wertes des Ausgangssignals $V_{OUT}$ dieser Schaltung jedoch keinen Unterschied macht.

Der Wert der Sourcespannung $V_s$ des ausgewählten Feldeffekttransistors 124, das heißt des ausgewählten Sensortransistors, deren Wert identisch ist mit dem an dem Eingang der Pufferschaltung 123 anliegenden Potential $V_{sense}$ ist eine Funktion des auf den Kanalbereich des ausgewählten Feldeffekttransistors 124 einwirkenden Potentials $V_{char}$, des Stroms durch den ausgewählten Feldeffekttransistor 124, der dem eingeprägten Strom $I_{IN}$ entspricht, und der Drainspannung an dem ausgewählten Feldeffekttransistor 124, gemäß **Fig.1** der Betriebsspannung $V_{RW}$.

Der eingeprägte Strom $I_{IN}$ wird derart gewählt, dass der ausgewählte Transistor 124 einen Arbeitspunkt einnimmt, so dass der ausgewählte Feldeffekttransistor 124 als Sourcefolger betrieben wird.

Dies ist möglich, indem der eingeprägte Strom $I_{IN}$ so gewählt wird, dass der ausgewählte Feldeffekttransistor 124 einen Arbeitspunkt in Inversion einnimmt, das heißt, dass gilt:

$$V_{char} - V_s > V_{th},\qquad(1)$$

wobei mit $V_{th}$ die Schwellenspannung des Feldeffekttransistors 124 bezeichnet wird, und die Drainspannung größer gewählt wird als die Differenz

$$V_{char} - (V_{th} + V_s),\qquad(2)$$

die der sogenannten effektiven Gatespannung des ausgewählten Feldeffekttransistors 124 entspricht.

Auf diese Weise stellt sich ein Arbeitspunkt des Feldeffekttransistors 124 im Sättigungsbereich ein und der Feldeffekttransistor wird wie gewünscht als Sourcefolger betrieben.

In diesem Zusammenhang wird ausgenutzt, dass unter den genannten Bedingungen der Transistorstrom nur eine geringe Abhängigkeit von der Drainspannung des ausgewählten Feldeffekttransistors aufweist und im wesentlichen durch die effektive Gatespannung bestimmt wird.

Da der Strom jedoch vorgegeben ist und die Spannung $V_{char}$ die zu charakterisierende Variable, das heißt das zu erfassende Signal ist, erfolgt anschaulich eine im wesentlichen lineare Abbildung der Spannung $V_{char}$ auf die Sourcespannung $V_s$ des ausgewählten Feldeffekttransistors.

Da, wie aus **Fig.1** ersichtlich ist, gilt:

$$V_{sense} = V_s,\qquad(3)$$

liegt an der ausgewählten zweiten Zeilenverbindung 106 ein um einen konstanten Betrag verändertes erfasstes Signal $V_{char}$ an. Änderungen $\Delta V_{char}$ des zu erfassenden elektrischen Signals $V_{char}$ führen somit zu Änderungen $\Delta V_{sense}$ an der ausgewählten Zeilenverbindung 106, wobei in guter Näherung gilt:

$$\Delta V_{sense} = \Delta V_{char}.\qquad(4)$$

Als Wert für die Spannung $V_{RW}$ wird vorzugsweise die positive Betriebsspannung $V_{DD}$ gewählt, mit der die Sensor-Anordnung 100 betrieben wird.

Alternativ kann der jeweilige ausgewählte Feldeffekttransistor 124 auch in einem Arbeitspunkt im sogenannten Unterschwellenbereich betrieben werden, das heißt derart, das gilt:

$$V_{char} - V_s < V_{th}.\qquad(5)$$

Ein solcher Arbeitspunkt ist einstellbar, falls ein sehr kleiner Strom $I_{IN}$ eingeprägt wird.

Auch in diesem Fall ist die Änderung der Sourcespannung des ausgewählten Feldeffekttransistors näherungsweise linear abhängig von der Änderung des auf den ausgewählten Feldeffekttransistor 124 einwirkenden elektrischen Signals $V_{char}$.

Als Ausgangssignal der Sensor-Anordnung 100, das in weiteren, nicht dargestellten signalverarbeitenden Schaltungskomponenten verwendet werden kann oder alternativ direkt ausgewertet werden kann, wird das an dem Ausgang 122 der Pufferschaltung 123 bereitgestellte gepufferte Messsignal $V_{sense,buf}$ verwendet.

Das an dem Ausgang 122 der Pufferschaltung 123 bereitgestellte gepufferte Messsignal $V_{sense,buf}$ ist niederohmig und somit belastbar, das heißt die Signalverarbeitung kann erfolgen, ohne dass Rückwirkungen auf die Sensor-Anordnung 100 durch die Signalverarbeitung zu befürchten sind.

Sofern der Abgriff des Messsignals hinreichend hochohmig erfolgt, beispielsweise mit Hilfe eines Verstärkers, dessen Eingänge durch die Gates von MOS-Feldeffekttransistoren gebildet werden, kann auch das Messsignal $V_{sense}$ direkt als Ausgangssignal verwendet werden.

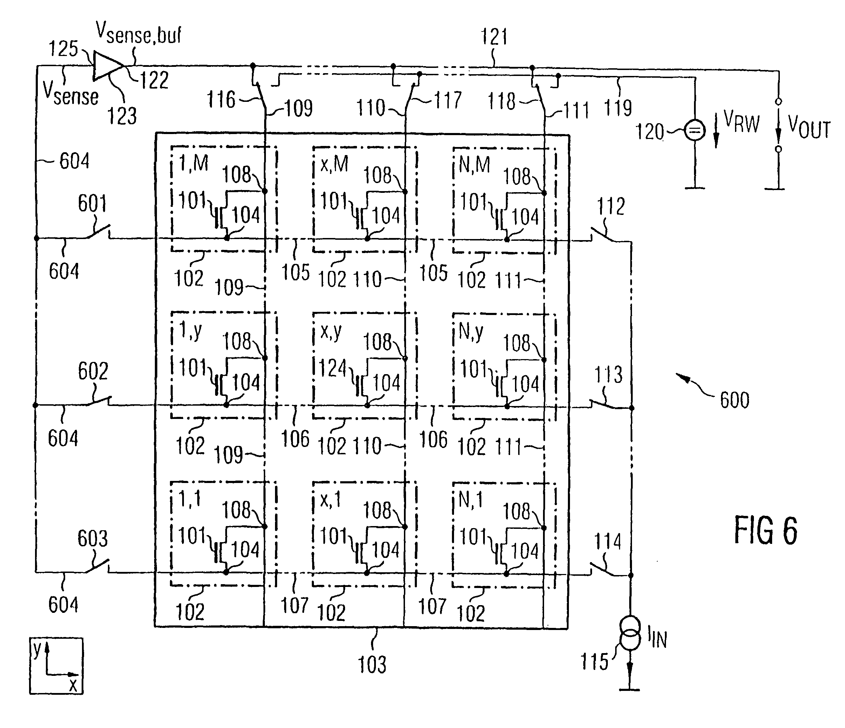

Bei einer Sensor-Anordnung 600 gemäß einem zweiten Ausführungsbeispiel, die in **Fig.6** dargestellt ist, sind zusätzlich zu den Zeilenauswahlschaltern 112, 113, 114 weitere Zeilenauswahlschalter 601, 602, 603 vorgesehen, die hinsichtlich der Zeilenauswahlschalter 112, 113, 114 an der gegenüberliegenden Seite der Sensor-Anordnung 600 angeordnet sind.

Gemäß der in **Fig.6** dargestellten Sensor-Anordnung 600 wird über die Zeilenauswahlschalter 112, 113, 114 der eingeprägte Strom $I_{IN}$ von der Stromquelle 115 der ausgewählten Zeilenverbindung 106 zugeführt. Über die weiteren Zeilenauswahlschalter 601, 602, 603 der ausgewählten Zeilenverbindung 106 wird das ausgewählte Spannungssignal $V_{sense}$ abgegriffen und dem Eingang der Pufferschaltung 123 als Messsignal $V_{sense}$ über Verbindungsleitungen 604 zugeführt, wodurch ein gepuffertes Ausgangssignal $V_{sense,buf}$ der Pufferschaltung 123 erzeugt wird.

Die weiteren Elemente der Sensor-Anordnung 600 gemäß dem zweiten Ausführungsbeispiel entsprechen der Sensor-Anordnung 100 gemäß dem ersten Ausführungsbeispiel.

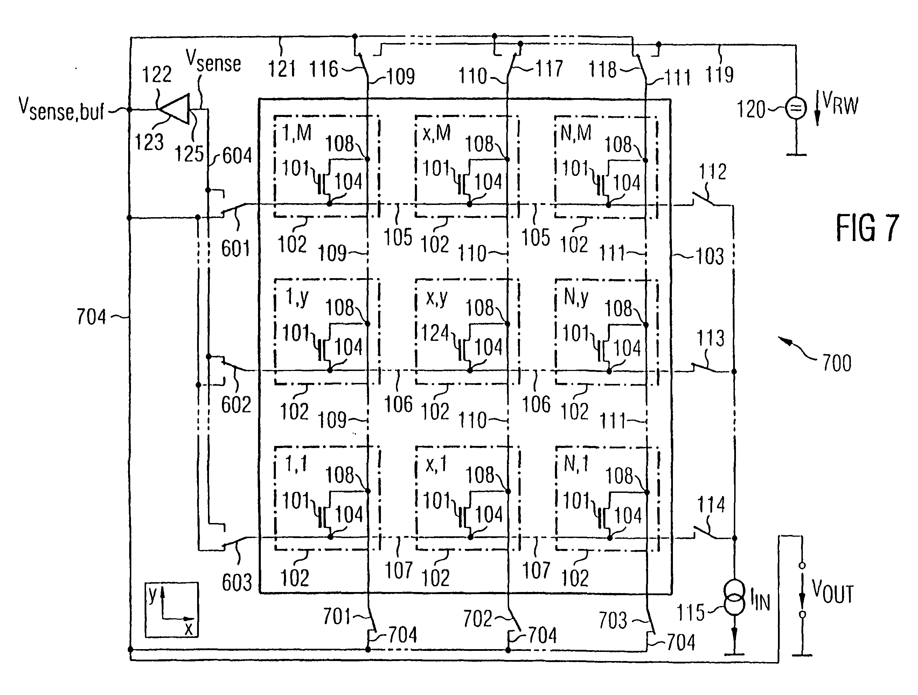

**Fig.7** zeigt eine Sensor-Anordnung 700 gemäß einem dritten Ausführungsbeispiel der Erfindung.

Gemäß dem dritten Ausführungsbeispiel sind weitere Spaltenauswahlschalter 701, 702, 703, verglichen mit der Sensor-Anordnung 600 gemäß dem zweiten Ausführungsbeispiel, vorgesehen.

Zusätzlich wird das gepufferte Messsignal $V_{sense,buf}$ am Ausgang 122 der Pufferschaltung 123 den weiteren Zeilenauswahlschaltern 601, 602, 603 derart über Rückkoppelverbindungen 704 zurückgekoppelt, dass die nicht ausgewählten Zeilenverbindungen 105, 107 aufgrund der entsprechenden Schalterposition der Zeilenauswahlschalter 601, 603, in der sie mit der entsprechenden Rückkoppelverbindung 704 gekoppelt sind, mit dem gepufferten Messsignal $V_{sense,buf}$ gekoppelt sind.

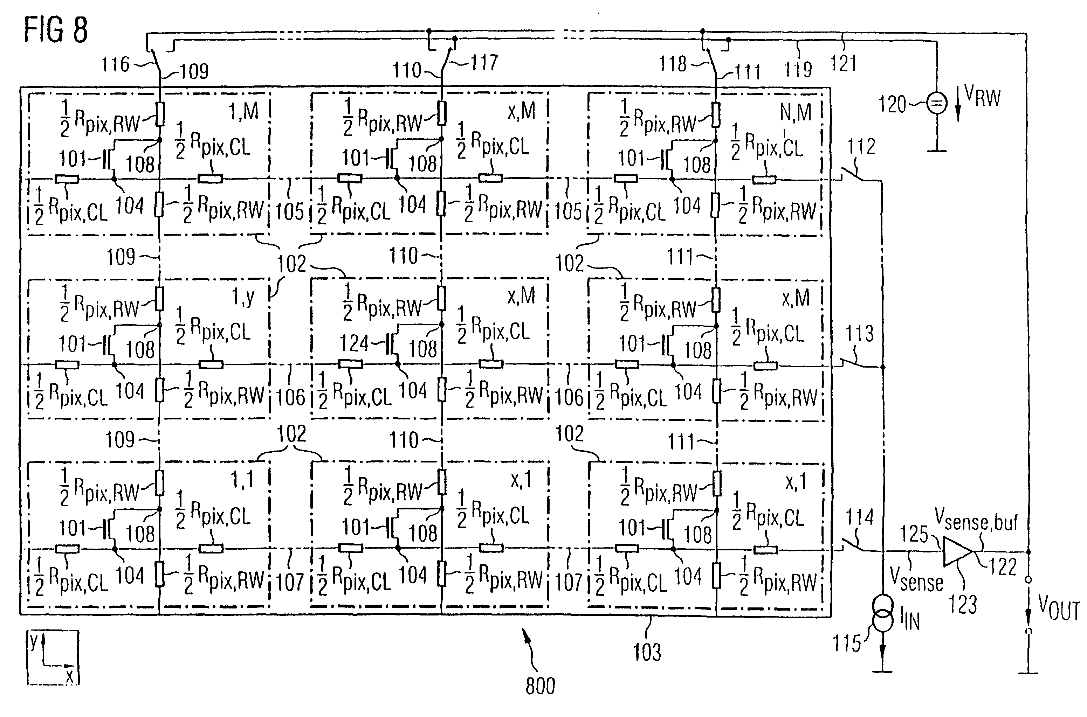

**Fig.8** zeigt eine Sensor-Anordnung 800, bei der parasitäre Effekte berücksichtigt werden.

Bei dieser Sensor-Anordnung 800 sind Parasitärwiderstände $R_{pix,RW}$, $R_{pix,CL}$, die sich aufgrund der Zeilenverbindungen 104, 105, 106 und der Spaltenverbindungen 109, 110, 111 für jede Sensorzelle 102 ergeben, dargestellt.

Für jede Sensorzelle 102 wird ein vorgegebenes Stück der entsprechenden Spaltenverbindung 109, 110, 111 bzw. der entsprechenden Zeilenverbindung 104, 105, 106 mit dem Parasitärwiderstand

$$R_{pix,RW} \left( = 2 \cdot \frac{1}{2} \cdot R_{pix,RW} \right)$$

bzw.

$$R_{pix,CL} \left( = 2 \cdot \frac{1}{2} \cdot R_{pix,CL} \right)$$

berücksichtigt.

Die Parasitärwiderstände $R_{pix,CL}$ und $R_{pix,RW}$ führen zu Spannungsabfällen auf den Zeilenverbindungen 105, 106, 107 bzw. Spaltenverbindungen 109, 110, 111, so dass sich innerhalb der Sensor-Anordnung 800 insgesamt ein relativ komplexes Profil bezüglich der Knotenpotentiale aller Knoten der Sensor-Anordnung 800 ergibt.

Wird die Dimensionierung der Sensor-Anordnung 800, das heißt werden die Abstände zwischen den einzelnen Sensorzellen 102 der Sensor-Anordnung 800 weiter verringert bei gleichbleibender oder steigender Anzahl von in der Sensor-Anordnung enthaltener Feldeffekttransistoren, dann sollten diese Parasitärwiderstände $R_{pix,CL}$ und $R_{pix,RW}$ berücksichtigt werden, da zum einen in diesem Fall nicht mehr unbedingt gewährleistet ist, dass der eingeprägte Strom $I_{IN}$ vollständig durch den ausgewählten Feldeffekttransistor 124 fließt. Dies ist vorliegend der Fall, da sich an den nicht ausgewählten Transistoren 101 innerhalb einer ausgewählten Zeile, d.h. innerhalb einer Zeile, die auch den ausgewählten Transistor 124 enthält, aufgrund des zuvor beschriebenen komplexen Potentialgefälles über dem gesamten Array, Drain-Source-Spannungen ungleich dem Wert 0 ergeben, so dass auch diese Transistoren stromführend sind.

Zum anderen bedingt der Spannungsabfall auf der Zeilenverbindung 105, 106, 107 bzw. Spaltenverbindung 109, 110, 111 zwischen der Stromquelle 115 und der Source 104 des ausgewählten Feldeffekttransistors 124, dass die Messspannung $U_{sense}$ nicht mehr identisch ist mit der Sourcespannung des ausgewählten Feldeffekttransistors 124. Die Differenz zwischen der Messspannung $V_{sense}$ und der Sourcespannung $V_s$ und die Differenz zwischen dem eingeprägten Strom $I_{IN}$ und dem durch den ausgewählten Feldeffekttransistor 124 tatsächlich hindurchfließenden Strom ist ferner abhängig von der Position des ausgewählten Feldeffekttransistors 124 innerhalb der Matrix 103 der Sensor-Anordnung 800.

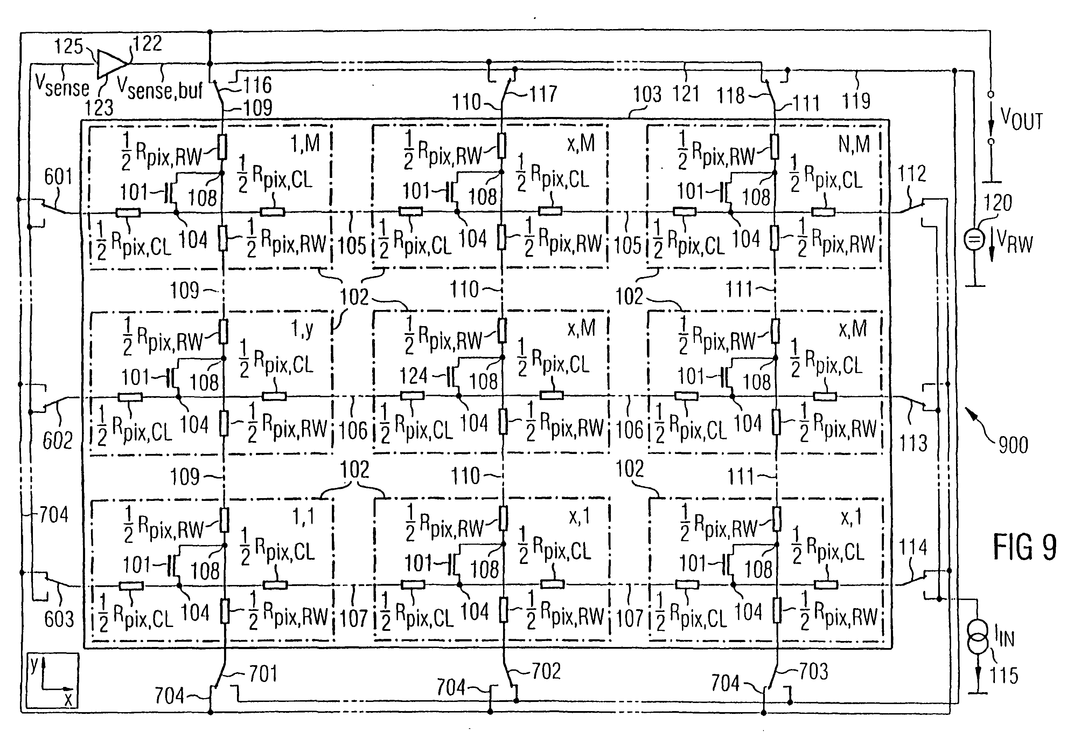

**Fig.9** zeigt eine Sensor-Anordnung 900, mit der die oben dargestellten Probleme bei weiter verringerter Dimensionierung der Sensor-Anordnung 800 bei gleichbleibender oder steigender Anzahl von in der Sensor-Anordnung enthaltener Feldeffekttransistoren minimiert werden, das heißt die durch die Parasitärwiderstände $R_{pix,CL}$ und $R_{pix,RW}$ sich ergebenden Messfehler optimiert kompensiert werden.

Die Kompensation ist insbesondere dadurch ermöglicht, dass die Einprägung des eingeprägten Stroms $I_{IN}$ mittels der Stromquelle 115 und das Erfassen des Messsignals $V_{sense}$ auf jeweils gegenüberliegenden Seiten der Sensor-Anordnung 900 erfolgen, und dass die gepufferte Messspannung $V_{sense,buf}$ am Ausgang 122 der Pufferschaltung 123 nicht nur an die Spaltenverbindungen 116, 117, 118 angelegt wird, sondern auch beidseits des Arrays an die nicht ausgewählten Zeilenverbindungen 105, 107 angelegt wird. Ferner werden die Spaltenpotentiale auf beiden Seiten der Spaltenverbindungen 116, 117, 118 der Sensor-Anordnung 900 angelegt.

Durch diese Sensor-Anordnung 900 wird bewirkt, dass der Teil der Zeilenverbindungen 105, 106, 107, der die Source des ausgewählten Feldeffekttransistors 124 mit dem Eingang 125 der Pufferschaltung 123, das heißt der Pufferschaltung 123 koppelt, näherungsweise stromlos ist. Somit erfolgt auf diesem Teil der Zeilenverbindung auch näherungsweise kein Spannungsabfall und das an der Source des ausgewählten Feldeffekttransistors anliegende Signal kann nahezu unverfälscht aus der Sensor-Anordnung 900 herausgelesen werden.

Um auch eine Sensor-Anordnung 900 mit sehr vielen Positionen bzw. mit kleinen geometrischen Abmessungen pro Sensorzelle 102 frei von Messfehlern betreiben zu können und um die Sensor-Anordnung 900 insbesondere hinsichtlich eines Betriebs der Feldeffekttransistoren mit relativ großen Strömen zum Reduzieren der Zugriffszeit auf den ausgewählten Feldeffekttransistor 124 zu verbessern, werden innerhalb der Sensor-Anordnung 900 neben den Feldeffekttransistoren 101 weitere Auswahlelemente zum Abkoppeln der entsprechenden Feldeffekttransistoren 101 in der Sensorzelle 102 vorgesehen, mit denen über Steuersignale eine gezielte Auswahl des gewünschten Feldeffekttransistors ermöglicht ist, ohne dass eine Verfälschung des durch den ausgewählten Feldeffekttransistor erfassten, zu charakterisierenden Signals eintritt.

Im weiteren werden solche Sensor-Anordnungen 900 mit zusätzlichen Auswahlelementen beschrieben.

Diesen Ausführungsbeispielen ist gemeinsam, dass die Einprägung des eingeprägten Stromes $I_{IN}$ und das Erfassen des Messsignals $V_{sense}$ auf jeweils gegenüberliegenden Seiten der Sensor-Anordnung erfolgen und folgende zwei Randbedingungen eingehalten werden:

- Der eingeprägte Strom $I_{IN}$ fließt vollständig über den ausgewählten Sensortransistor 124, das heißt den ausgewählten Feldeffekttransistor 124, der als Sensor ausgestaltet ist.
- Es entsteht ein Spannungsabfall nur auf dem Teil der mit der Source des ausgewählten Sensortransistors 124 verbundenen, in x-Richtung verlaufenden Zeilenverbindungen, der zwischen Source des ausgewählten Sensortransistors und der Stromquelle 115 liegt. Der Teil dieser Zeilenverbindung der zwischen Source des ausgewählten Sensortransistors und dem Signalabgriff des Messsignals $V_{sense}$ angeordnet ist, ist stromfrei, so dass auf diesem Teil der Zeilenverbindung kein Spannungsabfall erfolgt und das an der Source des ausgewählten Sensortransistors 124 anliegende Signal unverfälscht aus der Sensor-Anordnung ausgelesen werden kann.

Für die weitere Beschreibung wird auch folgende Nomenklatur verwendet. Die Sensor-Anordnung weist N Spalten 109, 110, 111, mit $1 \leq x \leq N$, und M Zeilen 105, 106, 107, mit $1 \leq y \leq M$ auf, wobei sich das ausgewählte Sensorelement 124 an der Position $(x, y)$ innerhalb der Sensor-Anordnung befindet.

Die Einhaltung dieser beiden oben dargestellten Bedingungen wird insbesondere dadurch gewährleistet, dass nur das Auswahlelement an der Spaltenposition des ausgewählten Sensortransistors 124, das heißt das Auswahlelement in der Sensorzelle des ausgewählten Feldeffekttransistors in geöffneten Zustand ist oder derart betrieben wird, während alle anderen der gleichen Zeile zuzuordnenden Auswahlelemente an den Positionen $(1, y)$ ..., $(x - 1, y)$, $(x + 1, y)$, ..., $(N, y)$ in gesperrtem Zustand sind oder derart betrieben werden.

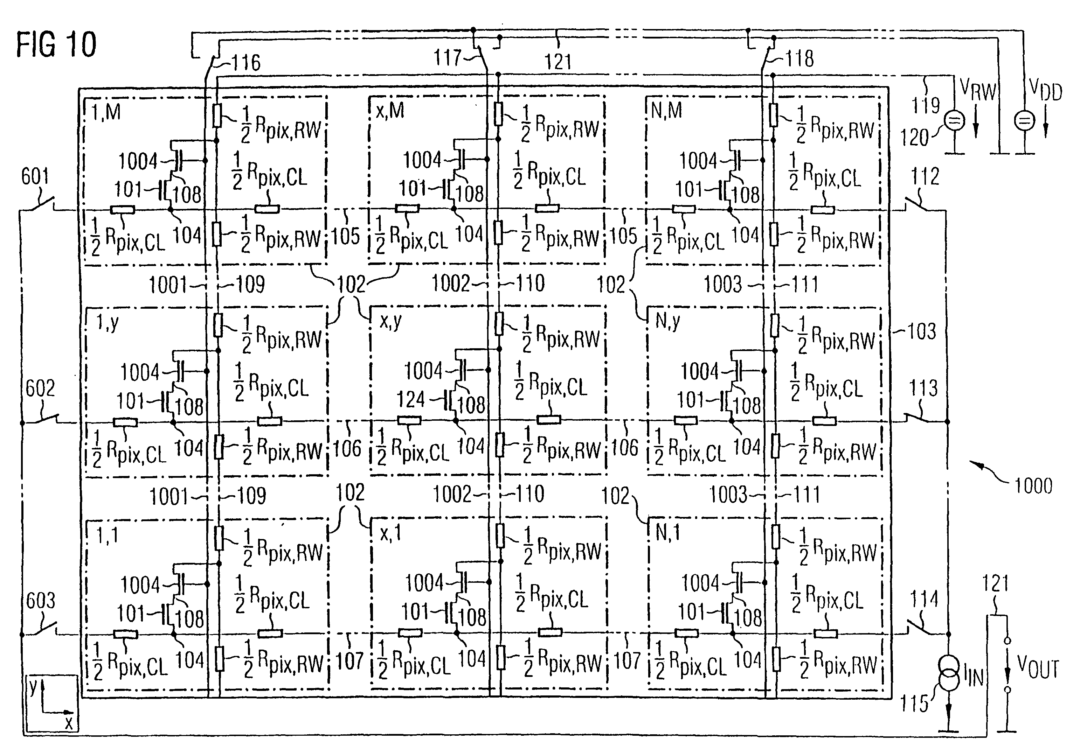

**Fig.10** zeigt eine Sensor-Anordnung 1000 gemäß einem fünften Ausführungsbeispiel, die die oben genannten Bedingungen erfüllt. Die Parasitärwiderstände $R_{pix,CL}$ und $R_{pix,RW}$ sind in den Sensorzellen 102 eingezeichnet. Die auch in den weiteren Auswahlleitungen 1001, 1002, 1003 auftretenden Parasitärwiderstände sind nicht dargestellt, da sie keine Messfehler während des Betriebs der Sensor-Anordnung 1000 verursachen.

Jede Sensorzelle 102 weist zwei aktive Elemente auf, nämlich den eigentlichen Sensortransistor 101 und jeweils einen Auswahltransistor 1004. Die Ansteuerung der Auswahltransistoren 1004 erfolgt über die in y-Richtung verlaufenden weiteren Auswahlverbindungen 1001, 1002, 1003.

An die weitere Auswahlleitung 1002 des ausgewählten Sensortransistors 124 wird beispielsweise die positive Betriebsspannung $V_{DD}$ angelegt, wobei die Spaltenauswahlschalter 116, 118 an den Positionen $(x, 1)$, ... $(x, M)$ mit der negativen Betriebsspannung gekoppelt sind.

An alle anderen Steuerleitungen 1001, 1002, 1003 wird ein Low-Pegel (das heißt eine negative Betriebsspannung $V_{SS}$) angelegt, so dass alle Auswahltransistoren 1004 an diesen Positionen in nicht leitendem Zustand sind.

Bezüglich der Wahl des eingeprägten Stroms $I_{IN}$ und der Spannung $V_{RW}$ gilt, dass diese Parameter derart gewählt werden, dass der ausgewählte Sensortransistor 124 in einem geeigneten Arbeitspunkt im Sättigungsbereich oder im Unterschwellenbereich betrieben wird, so dass Sourcefolgerbetrieb möglich ist.

Es ist zu berücksichtigen, dass die Drainspannung des Sensortransistors 101 der jeweiligen Sensorzelle 102 nicht nur durch den Wert der Betriebsspannung $V_{RW}$ und die Spannungsabfälle auf der in y-Richtung verlaufenden Leitung, das heißt Spaltenverbindung 109, 110, 111, die mit dem Auswahltransistor 1004 des ausgewählten Sensortransistors 124 verbunden ist, bestimmt ist, sondern auch durch die über dem stromdurchflossenen Auswahlelement selbst abfallende Spannung.

Wiederum kann für die Spannung $V_{RW}$ die positive Betriebsspannung $V_{DD}$ gewählt werden.

Die nicht ausgewählten Zeilenverbindungen 105, 107 können auch gemäß diesem Ausführungsbeispiel grundsätzlich mit jedem beliebigen Potential verbunden werden oder mit einem durch die Sensor-Anordnungen 900 bereitgestellten Potential verbunden werden, in dem die entsprechenden Zeilenauswahlschalter 112, 114 einfach in geöffneten Zustand belassen werden, wie dies in **Fig.10** dargestellt ist.

Alternativ können die nicht ausgewählten Zeilenverbindungen 105, 107 auf das Potential $V_{RW}$ gelegt werden. In diesem Fall sind die Auswahltransistoren 1004 und die Sensorelemente, das heißt die Sensortransistoren 101 an den Positionen (x, 1), ... (x, y - 1), (x, y + 1), ... (x, M) stromfrei und die Spannungsabfälle entlang der Spaltenverbindungen 109, 110, 111, die den Auswahltransistor 1004 des ausgewählten Sensortransistors 124 mit der Betriebsspannung $V_{RW}$ koppelt, werden minimiert, da diese Spaltenverbindung zusätzlich zu dem durch den ausgewählten Sensortransistor 124 fließenden Strom nicht noch weitere Ströme, die durch nicht ausgewählte Sensortransistoren der gleichen Spalte fließen, aufnehmen muss.

Alternativ können alle nicht ausgewählten Zeilenverbindungen 105, 107 mit dem über eine Pufferschaltung gelieferten gepufferten Messsignal $V_{sense,buf}$ gekoppelt werden.

Diese Anordnung kann bei Zeilenwechsel der ausgelesenen Sensorposition bzw. der Zugriffszeit Vorteile haben, da das Potential einer neu ausgewählten Zeilenverbindung schon nahe dem Wert liegt, der durch den neu ausgewählten Sensor bestimmt wird und somit weniger elektrische Ladung fließen muss, bis sich das neue Potential einstellt.

Es ist insbesondere in diesem Zusammenhang anzumerken, dass bei dieser Variante die Pufferschaltung 123 nicht unbedingt erforderlich ist.

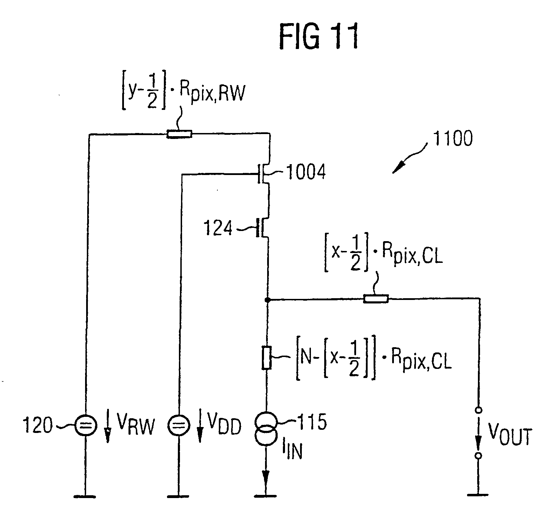

**Fig.11** zeigt das elektrische Ersatzschaltbild 1100 der in **Fig.10** dargestellten Sensor-Anordnung 1000.

In **Fig.11** sind ferner die sich aus $R_{pix,RW}$ und $R_{pix,CL}$ ergebenden Werte für die Gesamt-Parasitärwiderstände in dem elektrischen Ersatzschaltbild 1100 für eine Sensorzelle 102 an der Position (x, y) dargestellt.

Wie aus **Fig.11** ersichtlich ist, wird der ausgewählte Sensortransistor 124 wieder als Sourcefolger betrieben und es ergibt sich mit der Ausgangsspannung $V_{out}$ das unverfälschte Messergebnis, da der Teil der mit der Source 104 des ausgewählten Sensortransistors 124 verbundenen in x-Richtung verlaufenden Zeilenverbindungen, der zum Messsignalabgriff führt, stromfrei ist.

Wie aus **Fig.10** ersichtlich ist, wird in **Fig.10** die Spannung $V_{RW}$ an alle mit den Auswahltransistoren 1003 verbundenen Leitungen, das heißt weiteren Auswahlverbindungen $RW_{d,1}$, ..., $RW_{d,N}$ parallel jedoch nur von einer Seite der Sensor-Anordnung 1000 angelegt. Beidseitiges Anlegen der Spannung $V_{RW}$ an diese Leitungen kann vorteilhaft sein, da sich in diesem Fall der in y-Richtung wirksame Gesamtparasitärwiderstand $R_{tot,RW}$

$$R_{tot,RW} = \frac{1}{2} \cdot R_{pix,RW} + \sum_{i=1}^{y-1} R_{pix,RW} = \left(y - \frac{1}{2}\right) R_{pix,RW} \qquad (6)$$

in dem Ersatzschaltbild 1100 aus **Fig.11** zu

$$R_{tot,RW} = \frac{\left(y - \frac{1}{2}\right) \cdot \left[M - \left(y - \frac{1}{2}\right)\right]}{\left(y - \frac{1}{2}\right) + \left[M - \left(y - \frac{1}{2}\right)\right]} \cdot R_{pix,RW} =$$

$$= \left(y - \frac{1}{2}\right)\left[1 - \frac{y - \frac{1}{2}}{M}\right] \cdot R_{pix,RW} \qquad (7)$$

verringert.

Der Wert gemäß Vorschrift (7) ergibt sich aus der Parallelschaltung des oberhalb und unterhalb des ausgewählten Sensortransistors 124 liegenden Leitungsstücks.

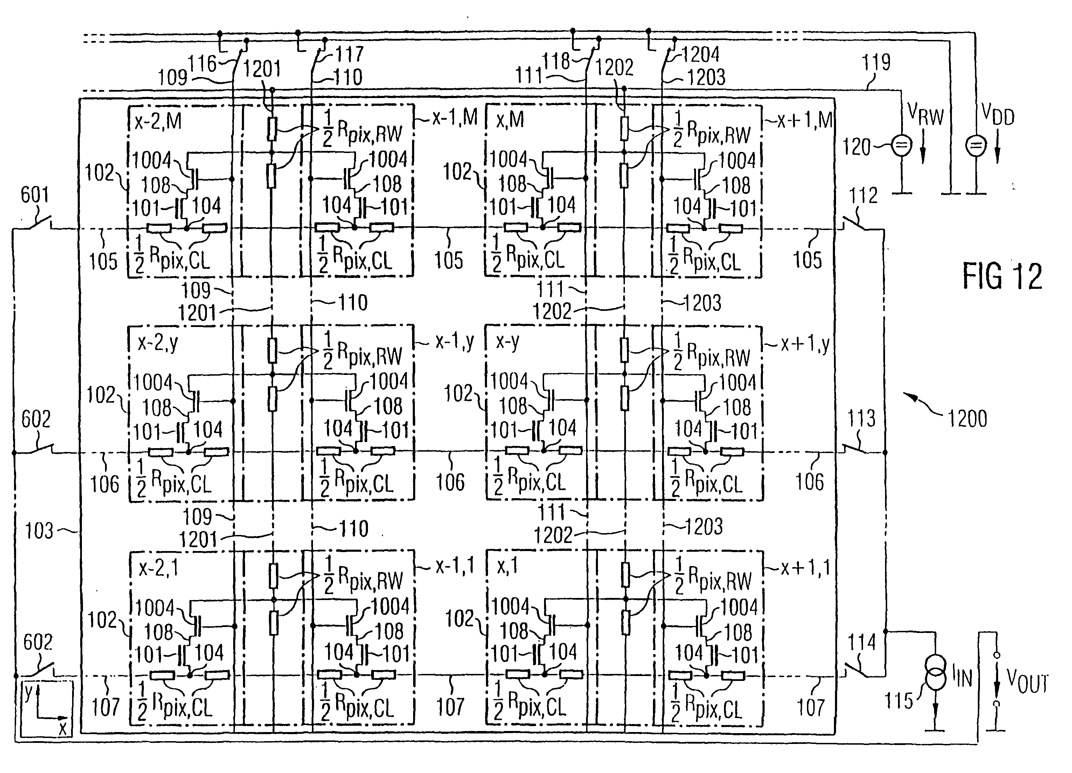

Bei der in **Fig.10** dargestellten Sensor-Anordnung 1000 sind doppelt so viele in y-Richtung verlaufende Spaltenverbindungen, verglichen mit den in den **Fig.1, Fig.6, Fig.7, Fig.8** und **Fig.9** dargestellten Sensor-Anordnungen vorgesehen. Um diese möglicherweise ungünstige Anordnung zu verbessern und um den Overhead an Leitungen gegenüber den Sensor-Anordnungen gemäß den **Fig.1, Fig.6, Fig.7, Fig.8** und **Fig.9** auf einen Faktor 1,5 zu verringern, wird die Sensor-Anordnung 1000 aus **Fig.10,** wie in **Fig.12** gezeigt, modifiziert, wodurch sich eine Sensor-Anordnung 1200 gemäß einem sechsten Ausführungsbeispiel ergibt.

Bei der Sensor-Anordnung 1200 gemäß **Fig.12** teilen sich jeweils zwei in x-Richtung benachbarte Sensorzellen 102 eine in y-Richtung verlaufende Auswahlleitung 1201, 1202. Die Spaltenverbindungen 109, 110, 111, 1203 sind jedoch nach wie vor individuell pro Spalte ausgeführt. Ferner ist in Fig.12 noch ein weiterer Spaltenauswahlschalter 1204 dargestellt.

Es ist in einer weiteren Ausgestaltung ohne weiteres möglich, dass sich auch mehr als zwei in x-Richtung benachbarte Sensorzellen 102 eine in y-Richtung verlaufende Zuleitung, teilen.

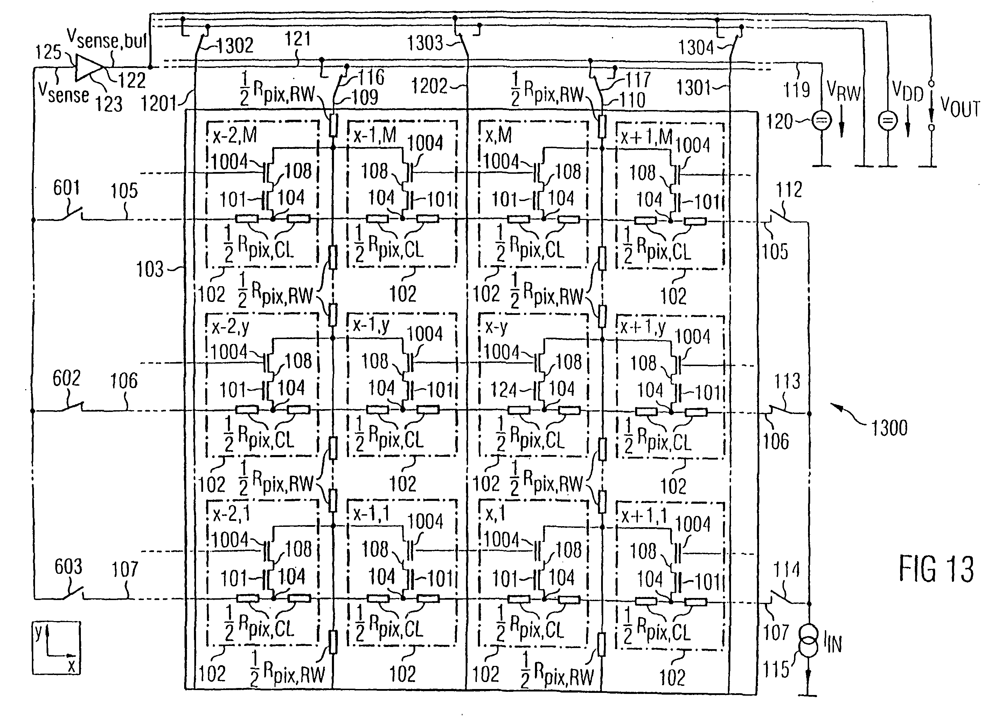

**Fig.13** zeigt eine Sensor-Anordnung 1300 gemäß einem siebten Ausführungsbeispiel der Erfindung, bei der für die Auswahl der Sensorzelle alle in y-Richtung verlaufenden Leitungen, das heißt sowohl die Spaltenverbindungen 109, 110, 111 als auch Auswahlleitungen 1201, 1202, 1301 mit weiteren Schaltern 1302, 1303, 1304 genutzt werden.

Auf diese Weise lässt sich der Overhead von zusätzlich benötigten Spaltenverbindungen vollkommen vermeiden. Alle zu den Drainknoten bzw. Gateknoten der Auswahltransistoren führenden Spaltenverbindungen sind in jeder Zeile jeweils mit den Drains bzw. den Gates zweier benachbarter Auswahltransistoren 1003 gekoppelt.

Lediglich die Leitungen am linken und am rechten Rand der Sensor-Anordnung 1300, die sowohl Drain-Zuleitungen als auch zwei Gate-Leitungen oder aber je eine Drain-Zuleitung und eine Gate-Leitung sein können, sind pro Zeile nur mit einem Drain bzw. Gate eines Auswahltransistors 1003 gekoppelt.

Auf diese Weise liegt der exakte Wert für den Faktor, der den Overhead beschreibt, bei $\frac{(M + 1)}{M}$, was für große Werte von M sehr nahe bei 1 ist.

Die Auswahl einer Sensorzelle 102 an der Position y erfolgt dadurch, dass die mit dem entsprechenden Auswahltransistor 1003 gekoppelte Gate-Auswahlleitung auf High-Pegel, das heißt auf die positive Betriebsspannung $V_{DD}$ gelegt wird, während an alle anderen Gate-Leitungen links und rechts davon ein Low-Pegel, das heißt die negative Betriebsspannung $V_{SS}$ angelegt wird, so dass alle Auswahltransistoren an diesen Positionen in nichtleitendem Zustand sind.

Ferner muss die mit dem entsprechenden Auswahltransistor 1003 gekoppelte Drain-Auswahlleitung auf Betriebsspannung $V_{RW}$ gelegt sein und die weiteren Drain-Auswahlleitungen sind kurzgeschlossen mit dem Ausgang des Pufferverstärkers oder sind mit dem Massepotential gekoppelt.

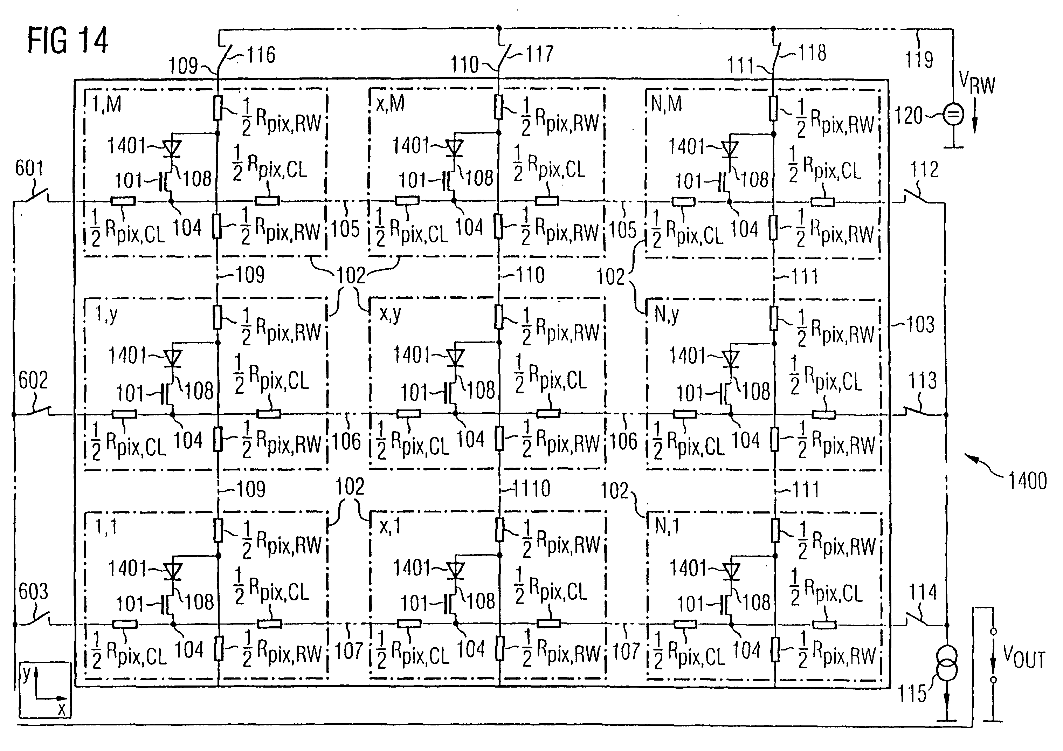

**Fig.14** zeigt eine Sensor-Anordnung 1400 gemäß einem achten Ausführungsbeispiel, bei der je eine Diode 1401 pro Sensorzelle 102 als Auswahlelement vorgesehen ist. Im Gegensatz zu den Sensor-Anordnungen 1000 und 1200, die in den **Fig.10** und **Fig.12** dargestellt sind, erfordert diese Sensor-Anordnung 1400 exakt die gleiche Anzahl von Zuleitungen in x-und y-Richtung wie die Sensor-Anordnungen gemäß den **Fig.1, Fig.6, Fig.7, Fig.8** und **Fig.9.**

An die ausgewählte Spaltenverbindung wird wieder die Spannung $V_{RW}$ angelegt, an die nicht ausgewählten Spaltenverbindungen kann entweder eine hinreichend niedrige Spannung angelegt werden, zum Beispiel das Massepotential, so dass die Dioden 1401 dieser Spalten in Sperrrichtung betrieben werden, oder es kann alternativ keine Verbindung zu einem von der Sensor-Anordnung 1400 bereitgestellten Potential hergestellt werden, in dem die entsprechenden Spaltenauswahlschalter einfach im geöffneten Zustand belassen werden.

Das Prinzip dieser Variante beruht darauf, dass sich zwischen ausgewählten Spaltenverbindung und der ausgewählten Zeilenverbindung ausgewählten Sensortransistors 124 kein weiterer Strompfad ergibt, bei welchem nicht mindestens eine Diode 1401 in Sperrrichtung liegt.

Die Dioden 1401 und damit die zugeordneten Sensortransistoren 101 in den nichtausgewählten Spalten, das heißt an den nichtausgewählten Spaltenverbindungen, sind stromlos.

Bezüglich der Wahl der Potentiale der nicht ausgewählten Zeilenverbindungen bzw. deren Ansteuerung gilt das im Zusammenhang mit **Fig.10** dargestellte.

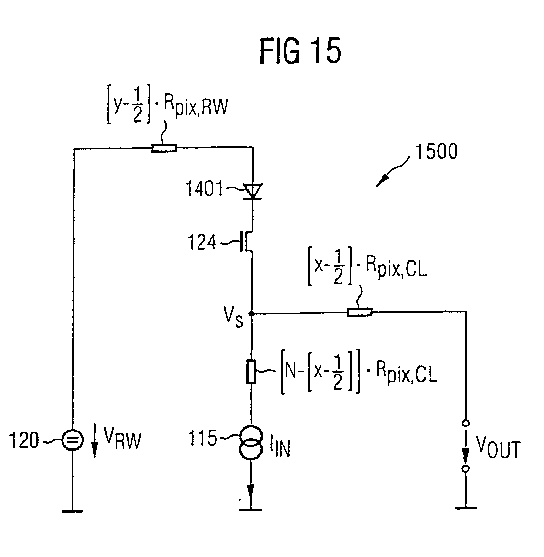

**Fig.15** zeigt das zu der Sensor-Anordnung 1400 aus **Fig.14** zugehörige elektrische Ersatzschaltbild 1500.

Ebenso kann auch hier eine beidseitige Zuführung der Potentiale der in y-Richtung verlaufenden Zuleitungen erfolgen, was zu analogen Ergebnissen führt, wie sie im Zusammenhang mit der Sensor-Anordnung 1000 aus **Fig.10** bereits oben dargestellt worden sind.

Die Diode 1401 einer Sensorzelle 102 in den **Fig.14** und **Fig.15** kann beispielsweise durch einen pn-Übergang realisiert werden.

Es kann jedoch auch ein MOS-Feldeffekttransistor in Diodenschaltung 1601, das heißt ein MOS-Feldeffekttransistor, bei dem Drain und Gate miteinander verbunden sind, eingesetzt werden.

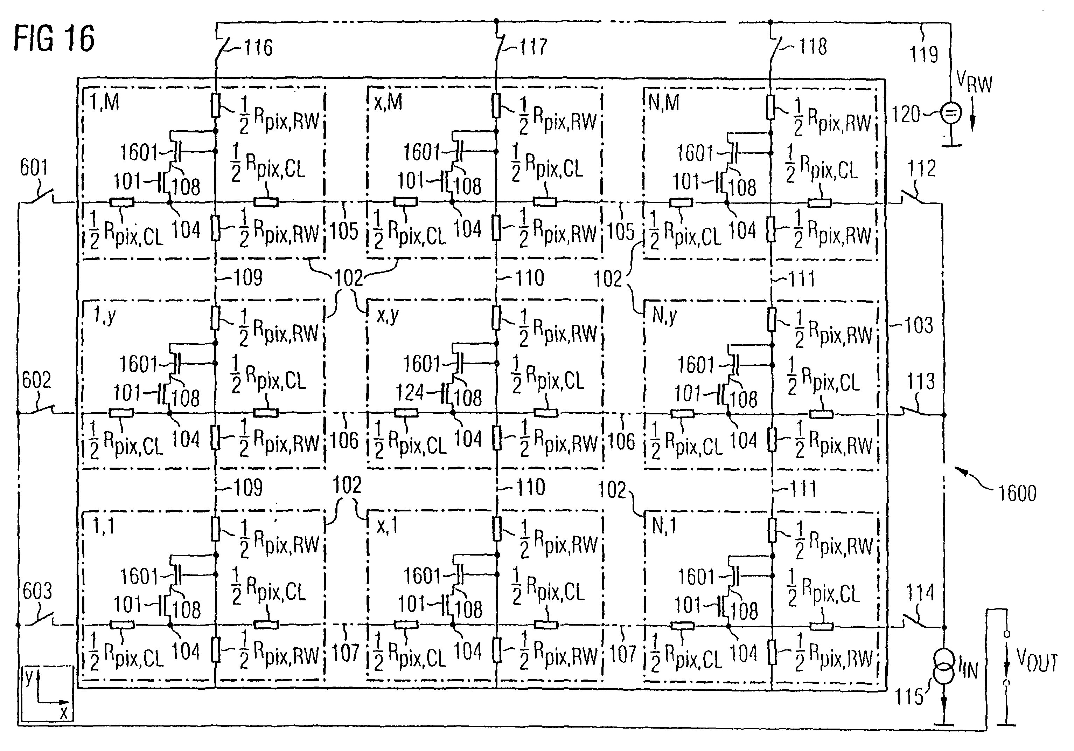

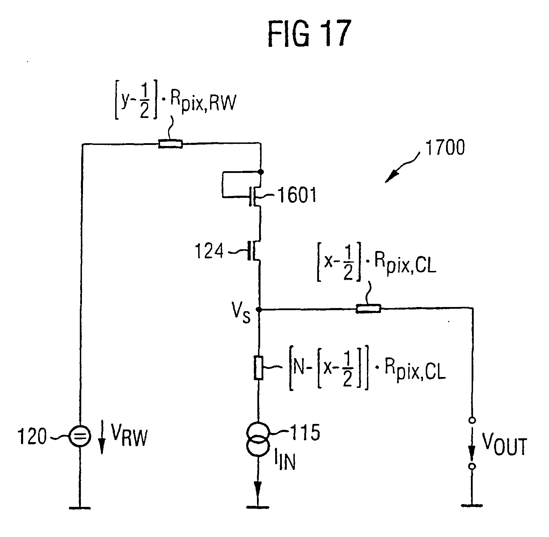

Es ergeben sich für diesen Fall anstelle des in **Fig.14** gezeigten Sensor-Anordnung 1400 die in **Fig.16** gezeigte Sensor-Anordnung 1600 und anstelle des in **Fig.15** dargestellten elektrischen Ersatzschaltbildes das in **Fig.17** dargestellte elektrische Ersatzschaltbild 1700.

In diesem Dokument sind folgende Veröffentlichungen zitiert:

[1] W.J. Parak et al, The field-effect-addressable potentiometric sensor/stimulator (FAPS) - a new concept for a surface potential sensor and stimulator with spatial resolution, Sensors and Actuators B, Chemical, Elsevier Science, S. 497 - 504, 1999

[2] R. Weis und P. Fromherz, Frequency dependent signal transfer in neuron transistors, Physically Review B, S. 877 ff, 1997

[3] W. Baumann et al, Microelectronic sensor system for microphysiological application on living cells, Sensors and Actuators, S. 77 ff, 1999

[4] DE 35 13 617 C2

[5] DE 198 56 295 A1

[6] JP-A-11 044 587

[7] US-A-4 568 444

[8] L. Bousse "A Process for the Combined Fabrication of Ion Sensors and CMOS Sensors", IEEE ELECTRON DEVICE LETTERS, USA, Bd. 9, Nr. 1, Januar 1998, Seiten 44 bis 46, XP001008777

**Patentansprüche**

1. Biosensor-Anordnung (100) mit Feldeffekttransistoren (101), die miteinander gekoppelt sind,

   • bei der die Feldeffekttransistoren (101) als Biosensoren ausgestaltet sind, wobei zumindest ein Teil der Feldeffekttransistoren (101) derart eingerichtet ist, dass sie bioelektrische signale von biologischem Material erfassen können,
   • bei der ein Auswahlmittel (112, 113, 114, 116, 117, 118) vorgesehen ist zum Auswählen eines Feldeffekttransistors (101), dessen Zustand erfasst werden soll,
   • bei der die Biosensor-Anordnung (100) derart eingerichtet ist, dass der ausgewählte Feldeffekttransistor (101) bei erfolgter Auswahl als Sourcefolger betrieben wird.

2. Biosensor-Anordnung (100) nach Anspruch 1, bei der die Feldeffekttransistoren (101) MOS-Feldeffekttransistoren sind.

3. Biosensor-Anordnung (100) nach Anspruch 1, bei der die Feldeffekttransistoren (101) ionensensitive Feldeffekttransistoren sind.

4. Biosensor-Anordnung (100) nach einem der Ansprüche 1 bis 3, bei der der ausgewählte Feldeffekttransistor (101) bei erfolgter Auswahl in einem Arbeitspunkt in Inversion betrieben wird.

5. Biosensor-Anordnung (100) nach einem der Ansprüche 1 bis 4, bei der der ausgewählte Feldeffekttransistor (101) bei erfolgter Auswahl in einem Arbeitspunkt im Unterschwellenbereich betrieben wird.

6. Biosensor-Anordnung (100) nach einem der Ansprüche 1 bis 5, bei der das Auswahlmittel (112, 113, 114, 116, 117, 118) derart eingerichtet ist, dass zum Erfassen eines Zustands des ausgewählten Feldeffekttransistors (101) eine Spannung angelegt wird, die gleich ist einer Betriebsspannung der Biosensor-Anordnung (100).

7. Biosensor-Anordnung (100) nach einem der Ansprüche 1 bis 6,

bei der die Feldeffekttransistoren (101) in Spalten und in Zeilen angeordnet sind und über Spaltenverbindungen (109, 110, 111) und Zeilenverbindungen (105 ,106, 107) miteinander gekoppelt sind.

8.  Biosensor-Anordnung (100) nach einem der Ansprüche 1 bis 7,
    bei der eine Stromquelle (115) vorgesehen ist, die mit den Source-Anschlüssen der Feldeffekttransistoren (101) koppelbar ist.

9.  Biosensor-Anordnung (100) nach einem der Ansprüche 1 bis 8,
    bei der eine Spannungsquelle vorgesehen (120) ist, die mit den Drain-Anschlüssen der Feldeffekttransistoren (101) koppelbar ist.

10. Biosensor-Anordnung (100) nach einem der Ansprüche 1 bis 9,
    bei der das Auswahlmittel (112, 113, 114, 116, 117, 118) Schalter aufweist, mittels derer ein Feldeffekttransistor (101) auswählbar ist.

11. Biosensor-Anordnung (100) nach einem der Ansprüche 1 bis 10,
    bei der für jeden Feldeffekttransistor (101) ein Auswahl mittel (112, 113, 114, 116, 117, 118) vorgesehen ist, mit dem der ausgewählte Feldeffekttransistor (101) leitend mit dem Auswahlmittel (112, 113, 114, 116, 117, 118) koppelbar ist, und mit dem der Stromfluss durch zumindest einen Teil der nicht ausgewählten Feldeffekttransistoren (101) sperrbar ist.

12. Biosensor-Anordnung (100) nach Anspruch 11,
    bei der das Auswahlelement eine Diode oder ein Transistor ist.

13. Biosensor-Anordnung (100) nach einem der Ansprüche 1 bis 12,
    bei der eine Pufferschaltung (123) vorgesehen ist, die mit den Feldeffekttransistoren (101) gekoppelt ist, wobei mit der Pufferschaltung (123) der jeweils erfasste Zustand pufferbar ist, wodurch das an ihrem Eingang anliegende Eingangssignal an ihrem Ausgang niederohmig bereitgestellt wird.

14. Biosensor-Anordnung (100) nach einem der Ansprüche 1 bis 13,
    bei der zumindest ein Teil der nicht ausgewählten Feldeffekttransistoren (101) mit einem oder mehreren vorgegebenen elektrischen Potentialen koppelbar ist.

15. Biosensor-Anordnung (100) nach Anspruch 13 oder 14,
    bei der eines der vorgegebenen Potentiale das am Ausgang der Pufferschaltung (123) bereitgestellte Signal ist.

16. Verfahren zum Erfassen eines Zustands eines Feldeffekttransistors (101) einer Biosensor-Anordnung (100), die miteinander gekoppelte Feldeffekttransistoren (101) aufweist,

    • wobei die Feldeffekttransistoren (101) als Biosensoren ausgestaltet sind, so dass der Zustand eines Feldeffekttransistors (101) abhängig ist von einem bioelektrischen signal eines zu erfassenden biologischen Materials, welches signal von dem Feldeffekttransistor (101) erfasst wird,
    • bei dem ein Feldeffekttransistor (101) ausgewählt wird,
    • bei dem der Zustand des ausgewählten Feldeffekttransistors (101) erfasst wird,
    • wobei der ausgewählte Feldeffekttransistor (101) bei erfolgter Auswahl als Sourcefolger betrieben wird.

**Claims**

1.  A bio-sensor array (100) having field effect transistors (101) that are coupled together,

    • in which the field effect transistors (101) are designed as bio-sensors, wherein at least some of the field effect transistors (101) are set up so that they can detect bio-electrical signals of biological material,
    • in which a means of selection (112, 113, 114, 116, 117, 118) is provided for selecting a field effect transistor (101) whose condition is to be detected,
    • in which the bio-sensor array (100) is set up so that the selected field effect transistor (101) can be driven as a source follower, at least when selection has been made.

**2.** The bio-sensor array (100) as claimed in claim 1,
in which at least some of the field effect transistors (101) are MOS field effect transistors.

**3.** The bio-sensor array (100) as claimed in claim 1,
in which the field effect transistors (101) are ion-sensitive field effect transistors.

**4.** The bio-sensor array (100) as claimed in one of claims 1 to 3,
in which the selected field effect transistor (101) can be driven at an operating point in inversion, at least when selection has been made.

**5.** The bio-sensor array (100) as claimed in one of claims 1 to 4,
in which the selected field effect transistor (101) can be driven at an operating point in the sub-threshold region, at least when selection has been made.

**6.** The bio-sensor array (100) as claimed in one of claims 1 to 5,
in which the means of selection (112, 113, 114, 116, 117, 118) is set up so that, in order to detect a condition of the selected field effect transistor (101), a voltage is applied that is equal to an operating voltage of the bio-sensor array (100).

**7.** The bio-sensor array (100) as claimed in one of claims 1 to 6,
in which the field effect transistors (101) are arranged in columns and in rows, and are coupled together via column connections (109, 110, 111) and row connections (105, 106, 107).

**8.** The bio-sensor array (100) as claimed in one of claims 1 to 7,
in which a current source (115) is provided that can be coupled to the source contacts of the field effect transistors (101).

**9.** The bio-sensor array (100) as claimed in one of claims 1 to 8,
in which a voltage source (120) is provided that can be coupled to the drain contacts of the field effect transistors (101).

**10.** The bio-sensor array (100) as claimed in one of claims 1 to 9,
in which the means of selection (112, 113, 114, 116, 117, 118) contains switches, by means of which a field effect transistor (101) can be selected.

**11.** The bio-sensor array (100) as claimed in one of claims 1 to 10,
in which a means of selection (112, 113, 114, 116, 117, 118) is provided for each field effect transistor (101), which can be used to couple the selected field effect transistor (101) conductively to the means of selection (112, 113, 114, 116, 117, 118), and which can be used to cut off the current flow through at least some of the unselected field effect transistors (101).

**12.** The bio-sensor array (100) as claimed in claim 11,
in which the selection element is a diode or a transistor.

**13.** The bio-sensor array (100) as claimed in one of claims 1 to 12,
in which a buffer circuit (123) is provided, which is coupled to the field effect transistors (101), where the condition being detected at the time can be buffered using the buffer circuit (123), by which means the input signal present at its input is made available at its output at low impedance.

**14.** The bio-sensor array (100) as claimed in one of claims 1 to 13,
in which at least some of the unselected field effect transistors (101) can be coupled to one or more defined electrical potentials.

**15.** The bio-sensor array (100) as claimed in claim 13 or 14,
in which one of the defined potentials is the signal made available at the output of the buffer circuit (123).

**16.** A method for detecting a condition of a field effect transistor (101) in a bio-sensor array (100) that contains field effect transistors (101) coupled together,

- in which the field effect transistors (101) are used as bio-sensors, so that the condition of a field effect transistor (101) depends on a bio-electrical signal of a biological material to be detected, which signal is detected by the field effect transistor (101),
- in which a field effect transistor (101) is selected,
- in which the condition of the selected field effect transistor (101) is detected, and
- where the selected field effect transistor (101) is driven as a source follower, at least when selection has been made.

**Revendications**

1. Dispositif formant biocapteur (100) comportant des transistors à effet de champ (101), qui sont couplés entre eux,

   - dans lequel les transistors à effet de champ (101) sont agencés sous la forme de biocapteurs, au moins une partie des transistors à effet de champ (101) étant agencée de telle sorte qu'ils peuvent détecter des signaux bioélectriques d'une matière biologique,
   - dans lequel un moyen de sélection (112, 113, 114, 116, 117, 118) est prévu pour sélectionner le transistor à effet de champ (101), dont l'état doit être détecté,
   - dans lequel le dispositif formant biocapteur (100) est agencé de telle sorte que le transistor à effet de champ (101) sélectionné fonctionne en tant que source suiveuse, lorsqu'une sélection est exécutée.

2. Dispositif formant biocapteur (100) selon la revendication 1, dans lequel les transistors à effet de champ (101) sont des transistors à effet de champ MOS.

3. Dispositif formant biocapteur (100) selon la revendication 1, dans lequel les transistors à effet de champ (101) sont des transistors à effet de champ sensibles aux ions.

4. Dispositif formant biocapteur (100) selon l'une des revendications 1 à 3, dans lequel le transistor à effet de champ sélectionné (101) fonctionne en un point de fonctionnement inversé, lorsqu'une sélection est exécutée.

5. Dispositif formant biocapteur (100) selon l'une des revendications 1 à 4, dans lequel le transistor à effet de champ (101) sélectionné fonctionne en un point de fonctionnement en dessous du seuil de déclenchement, lorsqu'une sélection est exécutée.

6. Dispositif formant biocapteur (100) selon l'une des revendications 1 à 5, dans lequel le moyen de sélection (112, 113, 114, 116, 117, 118) est agencé de telle sorte que pour la détection d'un état du transistor à effet de champ (101) sélectionné, une tension, qui est égale à une tension de fonctionnement du dispositif formant biocapteur (100), est appliquée.

7. Dispositif formant biocapteur (100) selon l'une des revendications 1 à 6, dans lequel les transistors à effet de champ (101) sont disposés suivant des colonnes et des lignes et sont couplés entre eux par l'intermédiaire de liaisons de colonnes (109, 110, 111) et de liaisons de lignes (105, 106, 107).

8. Dispositif formant biocapteur (100) selon l'une des revendications 1 à 7, dans lequel il est prévu une source de courant (115), qui peut être couplée aux électrodes de source des transistors à effet de champ (101) .

9. Dispositif formant biocapteur (100) selon l'une des revendications 1 à 8, dans lequel il est prévu une source de tension (120) qui peut être couplée aux électrodes de drain des transistors à effet de champ (101).

10. Dispositif formant biocapteur (100) selon l'une des revendications 1 à 9, dans lequel le moyen de sélection (112, 113, 114, 116, 117, 118) comporte des interrupteurs, à l'aide desquels on peut sélectionner un transistor à effet de champ (101).

11. Dispositif formant biocapteur (100) selon l'une des revendications 1 à 10, dans lequel pour chaque transistor à effet de champ (101), il est prévu un moyen de sélection (112, 113, 114, 116, 117, 118), avec lequel moyen de sélection (112, 113, 114, 116, 117, 118) le transistor à effet de champ (101) sélectionné peut être couplé, de façon conductrice, et avec lequel la circulation de courant à travers au moins une partie des transistors à effet de champ (101) non sélectionnés peut être bloqué.

**12.** Dispositif formant biocapteur (100) selon la revendication 11, dans lequel l'élément de sélection est une diode ou un transistor.

**13.** Dispositif formant biocapteur (100) selon l'une des revendications 1 à 12, dans lequel il est prévu un circuit de tampon (123), qui est couplé au transistor à effet de champ (101), l'état respectivement détecté pouvant être temporisé au moyen du circuit de tampon (123), ce qui a pour effet que le signal d'entrée présent à son entrée est délivré à sa sortie avec une faible valeur ohmique.

**14.** Dispositif formant biocapteur (100) selon l'une des revendications 1 à 13, dans lequel au moins une partie des transistors à effet de champ (101) non sélectionnés peuvent être couplés à un ou plusieurs potentiels électriques prédéterminés.

**15.** Dispositif formant biocapteur (100) selon la revendication 13 ou 14, dans lequel l'un des potentiels prédéterminés est le signal délivré à la sortie du circuit de tampon (123).

**16.** Procédé pour détecter un état d'un transistor à effet de champ (101) d'un dispositif formant biocapteur (100), qui comporte des transistors à effet de champ (101) couplés entre eux,

- selon lequel les transistors à effet de champ (101) sont agencés sous la forme de biocapteurs de sorte que l'état d'un transistor à effet de champ (101) dépend d'un signal bioélectrique d'une matière biologique à détecter, lequel signal est détecté par le transistor à effet de champ (101),
- selon lequel un transistor à effet de champ (101) est sélectionné,
- selon lequel l'état du transistor à effet de champ (101) sélectionné est détecté,
- le transistor à effet de champ (101) sélectionné fonctionnant en tant que source suiveuse lorsqu'une sélection est exécutée.

FIG 1

EP 1 272 860 B1

## FIG 2

## FIG 3

## FIG 4

## FIG 5A

## FIG 5B

FIG 6

FIG 7

EP 1 272 860 B1

FIG 8

FIG 9

EP 1 272 860 B1

FIG 10

EP 1 272 860 B1

24

# FIG 11

FIG 12

FIG 13

FIG 14

# FIG 15

$\left[y-\frac{1}{2}\right] \cdot R_{pix,RW}$

1500

1401

124

$\left[x-\frac{1}{2}\right] \cdot R_{pix,CL}$

$V_S$

$\left[N-\left[x-\frac{1}{2}\right]\right] \cdot R_{pix,CL}$

120    $V_{RW}$

115    $I_{IN}$

$V_{OUT}$

FIG 16

EP 1 272 860 B1

30

# FIG 17